Europäisches Patentamt

European Patent Office

Office européen des brevets

(11) Publication number: **0 226 546**
**A2**

# (12) EUROPEAN PATENT APPLICATION

(21) Application number: **86810589.1**

(22) Date of filing: **15.12.86**

(51) Int. Cl.⁴: **H 03 M 1/22**

(30) Priority: **17.12.85 JP 283643/85**
**17.12.85 JP 283644/85**

(43) Date of publication of application:
**24.06.87 Bulletin 87/26**

(84) Designated Contracting States:
**CH DE FR GB LI NL**

(71) Applicant: **Nippon Gakki Seizo Kabushiki Kaisha**
**10-1, Nakazawa-cho**
**Hamamatsu-shi Shizuoka-ken (JP)**

(72) Inventor: **Ijima, Kenzaburou**
**C/o Nippon Gaki Seizo K.K.**
**Shizuoka-Ken (JP)**

**Hayashi, Yoshinori**
**C/o Nippon Gaki Seizo K.K.**
**Shizuoka-Ken (JP)**

**Nonaka, Terumoto**
**C/o Nippon Gaki Seizo K.K.**
**Shizuoka-Ken (JP)**

**Usui, Akira**
**C/o Nippon Gaki Seizo K.K.**
**Shizuoka-Ken (JP)**

(74) Representative: **Nithardt, Roland**
**CABINET ROLAND NITHARDT Rue Edouard Verdan 15**
**CH-1400 Yverdon (CH)**

(54) **An improved displacement detector for an encoder.**

(57) In construction a displacement detector. analog input signals are first digitalized and thereafter processed all in the form of digital signals in order to rise degree of integration and dissolution with reduced influence of drifts.

Fig. I

EP 0 226 546 A2

**Description**

## AN IMPROVED DISPLACEMENT DETECTOR FOR AN ENCODER

Background of the invention

The present invention relates to an improved displacement detector for an encoder which is well suited for detection of linear or angular displacement.

One typical circuit for converting analog angular signals into corresponding digital signals includes an angle detector which is made up of a synchro control and a Scott-connected transformer. When a carrier wave signal $\sin\omega_0 t$ is supplied to the rotor of the synchro control transformer, its stator generates a synchronizing signal corresponding to the rotation angle $\theta$ of the rotor. When this synchronizing signal is supplied to the primary side of the Scott-connected transformer, the secondary side of the transformer generates analog signals $\sin\theta \cdot \sin\omega_0 t$ and $\cos\theta \cdot \sin\omega_0 t$ which are passed to respective demodulators. The demodulators removes the carrier wave components, i.e. $\sin\omega_0 t$, from the analog signals to issue angle signals $\sin\theta$ and $\cos\theta$ which are then put into respective analog multipliers. Output signals from the multipliers are passed to a common reducer which issues an difference signal $\sin(\theta - \Phi)$. The difference signal $\sin(\theta - \Phi)$ is passed to an up-down counter via a voltage control oscillator. The count value $\Phi$ of this counter is passed to a function generator which then, depending on the count value $\Phi$ of the counter, issues sine and cosine signals ($\sin\Phi$ and $\cos\Phi$). These signals are passed to the above-described analog multipliers for multiplication purposes.

With this system, the analog multipliers issue output signnals $\sin\theta \cdot \cos\Phi$ and $\cos\theta \cdot \sin\Phi$ and the output signal of the reducer is given by the following equation.
$$\sin\theta \cdot \cos\Phi - \cos\theta \cdot \sin\Phi = \sin(\theta - \Phi)$$

As a result. the output signal from the voltage control oscillator has a frequency corresponding to the value of $\sin(\theta - \Phi)$. Since the output signal $\Phi$ of the up-down counter changes depending on the value of $\sin(\theta - \Phi)$, the system operates as a sort of phase-locked loop which makes the value of $\sin(\theta - \Phi)$ be zero, i.e. makes $\theta$ be equal to $\Phi$. When $\Phi$ includes about 10 bits, the system has a degree of dissolution to divide the angular range of 0 to $2\pi$ into 1024 sections.

With this conventional displacement detector, most signals are processed in analog mode and, as a consequence, use of many analog circuit elements limits the degree of integration. Presently, even a hybrid integral circuit has a dimension of about 50 x 50 mm. In addition, variations in temperature of the voltage control oscillator and/or power source voltage tend to cause drift, thereby lowering the reliability of the detection.

Summary of the present invention

It is the object of the present invention to raise degree of integration and degree of dissolution of a displacement detector with minimized influence of drift.

In accordance with the present invention, the displacement detector for an encoder provided with a scale including a track generative of sine wave signals at the borders of constant domains is characterized by the first and second sensors arranged closely facing to and movable relative to said scale, generative of level signals corresponding to the intensity of the sine wave signals, and being spaced apart by phase lag of $1/4\lambda$ when $\lambda$ is the wavelength of the sine wave; the first and second A/D converters for digitalizing the level signals generated by the first and second sensors; a function generating and multiplying unit generative of the product of multiplication of the output signal of the first A/D converter with a cosine value corresponding to prescribed data, and the product of multiplication of the output signal of the second A/D converter with a sine value corresponding to the prescribed data, respectively; a reducer for calculating the difference between the products of multiplications; a counting unit which performs counting corresponding to the difference, shifts mode of counting depending on the polarity of the difference, and passes the count value to the function generating and multiplying unit, means for detecting the number of the domains passed by one of the first and second sensors depending on square pulses which are obtained by wave shape discrimination of the level signals from the first and second sensors; the function generating and multiplying unit, the reducer and the counting unit forming a phase-locked loop; and output signals of the counting unit and the detecting means being used as absolute displacement data.

Brief description of the drawings

Fig. 1 is a block diagram of the basic embodiment of the displacement detector in accordance with the present invention,

Fig. 2 is a wave shape diagram of signals processed through the system shown in Fig. 1,

Fig. 3 and 4 are block diagrams of modified embodiment of the displacement detector in accordance with the present invention, and

Fig. 5 is a block diagram of a conventional displacement detector.

Description of the preferred embodiments

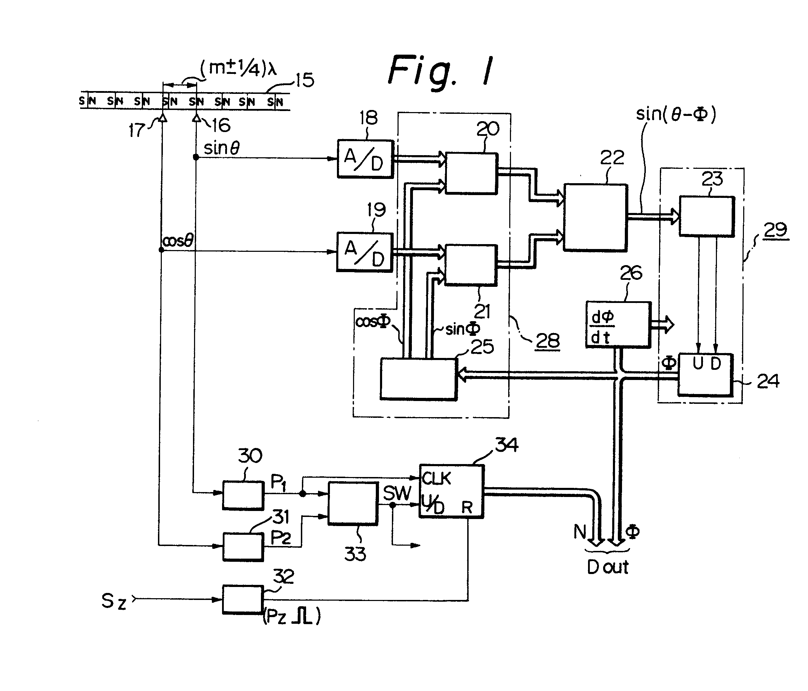

One embodiment of the displacement detector in accordance with the present invention is shown in Fig. 1, in which a scale 15 is in general formed by magnetizing a prescribed track with a sine wave of a constant period. In the case of this embodiment, a circular track is taken on the surface of a circular disc of a magnetic material for magnetization. The wave length $\lambda$ of the sine wave used for the magnetization is set in a range from several tens to several hundreds $\mu$m. Magnetic sensors 16 and 17 are arranged facing the scale 15 in order to generate level signal corresponding to the intensity of the magnetization on the scale 15. Semiconductor elements are preferably used for the magnetic sensors 16 and 17 so that their output signals should include no carrier waves. The magnetic sensor 17 has a phase lag of $1/4\lambda$ $(90^\circ)$ with respect to the magnetic sensor 16 and, as a consequence, the distance between the two magnetic sensors 16 and 17 is equal to $(m \pm 1/4)\lambda$ when m is a positive integer. The scale 15 and the magnetic sensors 16, 17 are arranged for a relative movement. When the output signal from the magnetic sensor 16 takes the form of a sine wave, the output signal from the magnetic sensor 17 takes the form of a cosine wave. So, when the interval of one period of the magnetizing sine wave, i.e. the distance between adjacent poles of the scale, is $\theta = 0 \sim 2\pi$, the output signals from the magnetic sensors 16 and 17 are given in the form of $\sin\theta$ and $\cos\theta$, respectively.

The magnetic sensors 16 and 17 are connected to A/D converters 18 and 19 which convert the output signals $\sin\theta$ and $\cos\theta$ into digitalized $\sin\theta$ and $\cos\theta$, respectively. The digitalized $\sin\theta$ and cos are passed to a common reducer 22 via respective multipliers 20 and 21. Then an output signal from the reducer 22 is passed to a digital comparator 23. When the result of reduction at the reducer 22 is positive, the digital comparator 23 passes an up-pulse to a counter 24 of 8 to 10 bits. Whereas the comparator 23 puts out a down-pulse when the result of the reduc tion is negative. The counter 24 passes a count value $\Phi$ to a function generating ROM (reed only memory) 25 which puts out sine data or cosine data corresponding to the count value $\Phi$. Data of $\sin\Phi$ and $\cos\Phi$ are stored in the function generating ROM25 in order to be read out in accordance with count value $\Phi$ from the counter 24. The data of $\cos\Phi$ are put in the multiplier 20 whereas the data of $\sin\Phi$ are put in the multiplier 21. With this construction, the output signal from the reducer 22 is equal to $\sin(\theta - \Phi)$. The comparator 23 puts out an up-pulse when $\sin(\theta - \Phi)$ is positive and puts out a down-pulse when $\sin(\theta - \Phi)$ is negative. As a consequence, the count value $\Phi$ of the counter 24 changes depending on the value of $\sin(\theta - \Phi)$. The multipliers 20, 21 and the function generating ROM25 form a function generating and multiplying unit 28 whereas the comparator 23 and the counter 24 form a counting unit 29. Further, the count value $\Phi$ from the counter 24 is passed to a speed detector 26 which differentiate the put in count value. The operation of the speed detector 26 will be later explained in more detail.

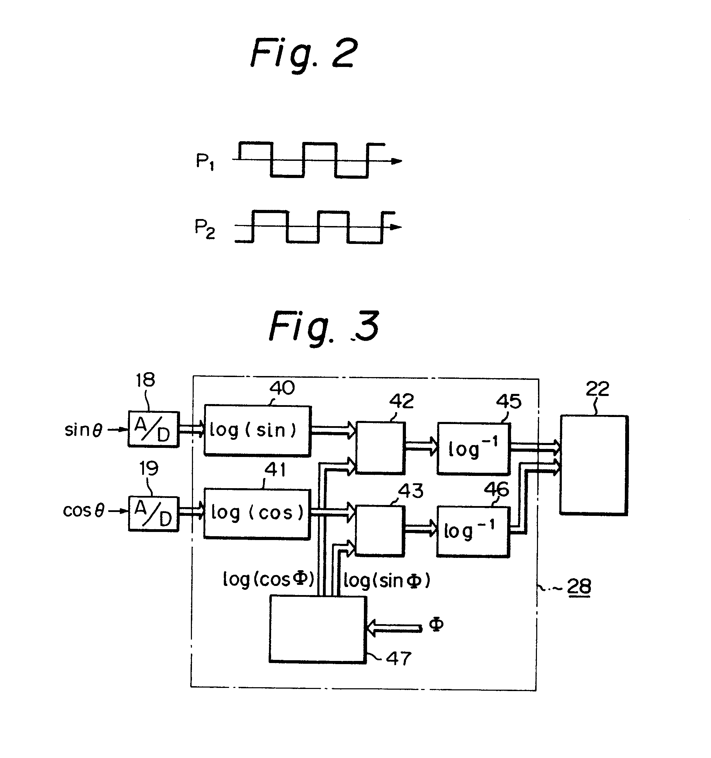

The output signals from the magnetic sensors 16 and 17 are passed to wave shape discriminators 30 and 31 also, respectively. The wave shape discriminator 30 compares the output signal with a prescribed threshold value and, depending on the size of the output signal, puts out a two-value signal $P_1$ assuming a H-level (high level) and a L-level (low level). In the same way, the wave shape discriminator 31 issues a two value signal $P_2$. As shown in Fig. 2, the two-value signals $P_1$ and $P_2$ take the form of square wave having a phase lag of $\pi/2$. When the magnetic sensors 16 and 17 move in the positive direction, the pulse $P_1$ is ahead. When the magnetic sensors 16 and 17 move in the negative direction, the pulse $P_2$ is ahead.

The wave shape discriminators 30 and 31 are connected to a common direction discriminator 33 which discriminates the moving direction of the magnetic sensors 16 and 17. For example, discrimination is carried out by finding the level of the pulse $P_2$ at rise of the pulse $P_1$. The output signal Sw is in one way passed to the up-down shifting terminal U/D of a counter 34 and in the other way passed outside the system. The counter 34 shifts between up- and down- modes while counting the pulse $P_1$ From the wave shape discriminator 30. In the case of this embodiment, the positive direction movement of the magnetic sensors 16 and 17 causes up-mode counting and the negative movement causes down-mode counting. Every time the magnetic sensors 16 and 17 have performed one complete circulation along the scale 15, the zero-point signal Sz issued at the reference position is converted to a zero-point pulse Pz after passage through a wave shape discriminator 32, which is then passed to the reset terminal R of the counter 34. As a consequence, the count value of the counter 34 exists between the current and reference positions of the magnetic sensors 16 and 17, and corresponds to the number of the magnetic domains (the number of magnetic poles) which the magnetic sensors 16 and 17 have passed by. The output signal N of the counter 34 and the output signal $\Phi$ of the counter 24 are issued outside the system as absolute displacement data Dout. In this case, one output signal N of the counter 34 forms a higher bit and one output signal $\Phi$ of the counter 24 forms a lower bit of the absolute displacement date Dout.

The displacement detector in Fig.1 operates as follows.

First, assuming that the magnetic sensors 16 and 17 move in the positive direction, the counter 34 repeats up-mode counting every time the magnetic sensors 16 and 17 have passed one magnetic domain on the scale 15 and the count values N are put out sequentially to form the higher bits of the absolute displacement data Dout. From observation of the higher bits of the absolute displacement data Dout, one can learn how many magnetic domains have been passed by the magnetic sensors 16 and 17, i.e. how many pitches are the magnetic sensors 16 and 17 distant from the reference position.

The output signals $\sin\theta$ and $\cos\theta$ are digitalized at the A/D converters 18 and 19 and multiplied with the output signals $\cos\Phi$ and $\sin\Phi$ from the function generating ROM 25. In response to the results of the multiplication, the reducer 22 puts out the signal $\sin(\theta - \Phi)$. When the signal $\sin(\theta - \Phi)$ is positive, the count value $\Phi$ at the counter 24 increases. Whereas the count value $\Phi$ decreases when the signal $\sin(\theta - \Phi)$ is negative. The output signals $\cos\Phi$ and $\sin\Phi$ change in accordance with change in the count value $\Phi$. Thus the circuit in Fig.1 operates as a sort of phase-locked loop which operates to make $\sin(\theta - \Phi)$ be equal to zero, i.e. to make $\theta$ equal to $\Phi$. So, the count value $\Phi$ indicates at what position in the magnetic sensor 16 located within a certain magnetic domain on the scale 15. As a consequence. sequential count values Φ from the counter 24 form the lower bits of the absolute displacement data Dout. Since the counter 24 includes 8 to 10 bits, the degree of dissolution of the position within a magnetic domain is in a range from $1/256 \sim 1/2048$.

The operation of the speed detector 26 will now be explained in detail. As remarked above. the system is controlled so that the value Φ should be equal to . So, the count value Φ changes corresponding to the relative speed of the magnetic sensors 16 and 17. In other words, the rate of change in the count value (dΦ/dt) corresponds to the relative speed of the magnetic sensors 16 and 17 and the speed detector 26 issues a speed signal. The moving direction of the magnetic sensors 16 and 17 can be learned by observing the polarity of this speed signal.

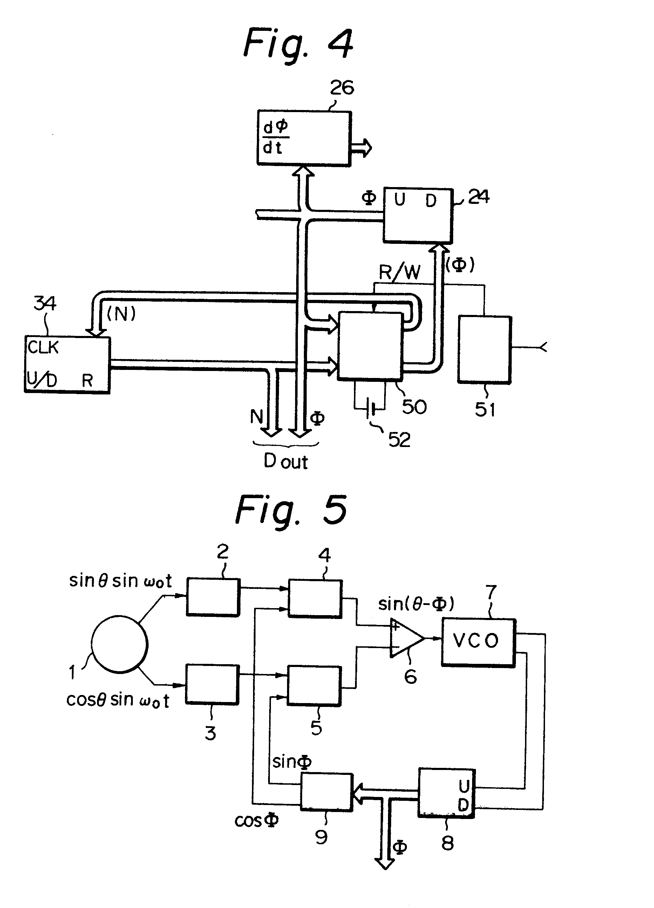

In accordance with the present invention, the system is constructed so that, except for the output signals sin and cos from the magnetic sensors 16 and 17, only digital signals are processed throughout the system and, as a consequence, significant reduction in number of analog circuit element enables high degree integration on a monolithic semiconductor substrate. In a test production conducted by the inventors, a highly integrated circuit could be encased in a flat package of 5x7x1 mm. In the case of a conventional hybrid integrated circuit of a similar function, a package of 50x50x10 mm is needed. The drifts of the system caused by temperature change (-20 to +80°C) and voltage change ($\pm 20\%$) were compared with those of the conventional one shown in Fig.5. The conventional system presented $\pm 2$ bits drifts in response to the temperature and voltage changes. Under the same conditions, the system of the present invention presented $\pm$ bit drifts only. In accordance with the present invention, the lowest bit of the absolute displacement data Dout corresponds to the lowest bit of the data indicating a finest position within a certain magnetic domain and, consequently, the drift yields only very small influence on the correct operation of the system.

In the conventional system shown in Fig.5, output signals $\sin\theta \cdot \sin\omega_0 t$ and $\cos\theta \cdot \sin\omega_0 t$ of an angle detector 1 are passed to demodulators 2 and 3 and output signals of the demodulators 2 and 3 are passed to a common reducer 6 after multiplication by multipliers 4 and 5, respectively. The output signal $\sin(\theta - \Phi)$ of the reducer 6 is passed to a counter 8 via a voltage control oscillator 7 and each count value Φ from the counter 8 is passed to a function generator 9 which thereon generates output signal cosΦ and sinΦ for multiplication at the multipliers 4 and 5.

Another embodiment of the displacement detector in accordance with the present invention is shown in Fig.3, in which a modified function generating and multiplying unit 28 is used for processing of logarithmic signals. The system includes logarithm tables 40 and 41 which store logarithmic values of sine and cosine over the angle range of 0 to $2\pi$. On receipt of the data fed by the A/D converters 18 and 19. the logarithm tables 40 and 41 pass corresponding logarithmic values of sine and cosine to adders 42 and 43. A function generating ROM 47 is provided to generate output signals log(cosΦ) and log (sinΦ) on receipt of the count value Φ from the counter 24 (see Fig.1). The output signal log (cosΦ) is passed to the adder 42 whereas the output signal log(sinΦ) is passed to the adder 43. Results of addition at the adders 42 and 43 are passed to counter logarithm circuits 45 and 46 in order to obtain their counter logarithmic values. The counter logarithm circuits 45 and 46 generates output signals $\sin\theta \cdot \cos\Phi$ and $\cos\theta \cdot \sin\Phi$. On receipt of these output signals, the reducer 22 generates an output signal $\sin(\theta - \Phi)$ as in the case of the system shown in Fig.1.

Instead of the circular track employed in the foregoing embodiments, a linear track can also be used in the present invention. Further, instead of the magnetic encoder, the present invention is well applicable to optical encoders too.

As is clear from the foregoing description, the present invention assures high degree of integration on a monolithic semi-conductor substrate, high degree of dissolution in displacement detection and reduced influence of drift to be caused by change in voltage and/or temperature. In real use of the displacement detector. however, it is preferably required the result of detection should be obtained upon activation of the power source. The other embodiment of the present invention shown in Fig.4 well suffices this requirement. Here, processing of the output signals Φ and N from the counters 24 and 34 is somewhat modified from that in Fig.1.

More specifically. a non-volatile static RAM 50 accompanied with a battery 52 is connected to a power source monitor 51 which detects the moment of activation and deactivation of the power source. The power source monitor 51 generates a read signal R when the power source is activated, and a write signal W when the power source is deactivated, both signals being passed to the static RAM 50. On receipt of a write signal W, the static RAM 50 stores the count values Φ and N from the counters 24 and 34. On receipt of a read signal R, the static RAM 50 passes the stored count values (Φ) and (N) to the present data input terminals of the counters 24 and 34, respectively.

This embodiment operates as follows. When the entire system has ceased its operation and the power source is deactivated, the power source monitor 51 passes a write signal W to the static RAM 50 at the moment of deactivation and the static RAM 50 stores the count values Φ and N which correspond to the displacement of the magnetic sensors 16 and 17 at this very moment. When the power source is again activated to initiate the operation of the entire system, the power source monitor 51 passes a read signal R to the static RAM 50 which thereupon supplies the stored count values (Φ) and (N) to the preset data input terminals of the counters 24 and 34, respectively. Then the initial values of the counters 24 and 34 become the preceding values, respectively. As a result, the absolute displacement data Dout corresponds to the displacement of the magnetic sensors 16 and 17 at the very moment of activation of the power source. Thus the result of detection can be obtained upon activation of the power source.

## Claims

1. An improved displacement detector for an encoder provided with a scale including a track generative of sine wave signals at the borders of constant domains comprising

the first and second sensors arranged closely facing to and movable relative to said scale, generative of level signals corresponding to the intensity of said sine wave signals, and being spaced apart by a phase lag of $1/4\ \lambda$ when $\lambda$ is the wavelength of said sine wave,

the first and second A/D converters for digitalizing said level signals generated by said first and second sensors,

a function generating and multiplying unit generative of the product of multiplication of the output signal of said first A/D converter with a cosine value corresponding to prescribed data, and the product of multiplication of the output signal of said second A/D converter with a sine value corresponding to said prescribed data, respectively,

a reducer for calculating the difference between said products of multiplications,

a counting unit which performs counting corresponding to said difference, shifts mode of counting depending on the polarity of said difference, and passes the count value to said function generating and multiplying unit, and

means for detecting the number of said domains passed by one of said first and second sensors depending on square pulses which are obtained by wave shape discrimination of said level signals from said first and second sensors.

said function generating and multiplying unit, said reducer and said counting unit forming a phase-locked loop, and

output signals from said counting unit and said detecting means being used as absolute displacement data.

2. An improved displacement detector according to claim 1 in which

said counting unit includes a preset data input terminal,

said detecting means includes a preset data input terminal, and

non-volatile data storing means is provided, which stores output data from said counting unit and said detecting means at deactivation of a power source and supplies stored data to said preset data terminals of said counting unit and said detecting means.

3. An improved displacement detector according to claim 1 or 2 in which

said output signal from said counting unit forms the lower bits of said absolute displacement data and said output signal from said detecting means forms the higher bits of said absolute displacement data.

4. An improved displacement detector as claimed in claim 1 or 2 in which

that said function generating and multiplying unit includes multipliers connected to said A/D converters, and a function gen erating ROM connected, on the input side, to said counting unit and, on the output side, to said multipliers.

5. An improved displacement detector according to claim 1 or 2 in which

said counting unit includes a comparator connected to said reducer, and a first counter connected, on the input side, to said comparator and, on the output side, to said function generating and multiplying unit.

6. An improved displacement detector according to claim 1 or 2 in which

said detecting means includes wave shape discriminators connected to said sensors, a direction discriminator connected to said wave shape discriminators and a second counter connected on the input side to said direction discriminator.

7. An improved displacement detector according to claim 1 or 2 in which

said encoder is a magnetic encoder and said sensors are magnetic sensors.

8. An improved displacement detector according to claim 1 or 2 in which

said encoder is an optical encoder and said sensors are photoelectric sensors.

9. An improved displacement detector according to claim 1 or 2 in which

said circuit elements are all arranged on a monolithic semi-conductor substrate.

Fig. 1

0226546

## Fig. 2

P₁

P₂

## Fig. 3

# Fig. 4

# Fig. 5